Europäisches Patentamt

European Patent Office

Office européen des brevets

(19)

(11) **EP 0 720 173 A1**

(12) **DEMANDE DE BREVET EUROPEEN**

(43) Date de publication:
03.07.1996 Bulletin 1996/27

(51) Int Cl.⁶: **G11C 11/412**, H03K 3/037, H03K 3/356

(21) Numéro de dépôt: 95402715.7

(22) Date de dépôt: 01.12.1995

(84) Etats contractants désignés:
**CH DE FR GB LI NL**

(30) Priorité: **05.12.1994 FR 9414592**

(71) Demandeur: **C.S.E.M. CENTRE SUISSE D'ELECTRONIQUE ET DE MICROTECHNIQUE SA**
**CH-2007 Neuchâtel (CH)**

(72) Inventeurs:
• **Piguet, Christian**
**CH-2000 Neuchâtel (CH)**
• **Masgonty, Jean-Marc**
**CH-2035 Corcelles (CH)**

(74) Mandataire: **Colas, Jean-Pierre et al**
**Cabinet de Boisse,**
**L.A. de Boisse - J.P. Colas,**
**37, avenue Franklin D. Roosevelt**
**75008 Paris (FR)**

(54) **Element de memoire statique du type bascule latch**

(57)    Il comprend des première (4) et deuxième (5) portes logiques alimentées l'une par la variable logique d'entrée (D) et toutes deux par un signal d'horloge (E) monophasique. La sortie de la première porte (4) alimente une entrée de la deuxième porte (5) et la sortie (Q) de cette dernière est bouclée sur une entrée d'au moins une des deux portes.

Application à des latchs à haute fréquence de fonctionnement et basse consommation.

FIG.:2A

EP 0 720 173 A1

**Description**

La présente invention est relative à un élément de mémoire statique du type bascule D "latch" et, plus particulièrement, à un tel élément de mémoire statique propre à transférer une variable logique d'entrée sur une sortie sous la commande d'un signal d'horloge, comprenant des première et deuxième portes logiques alimentées l'une par la variable logique d'entrée et toutes deux par le signal d'horloge.

On connaît dans la technique la bascule latch ou "latch" représentée à la figure 1A du dessin annexé, bascule dans laquelle une variable d'entrée D est traitée dans un inverseur 1, à sortie commandée par un signal d'horloge E et un autre signal d'horloge EN complémentaire du premier, la sortie de cet inverseur passant dans un deuxième inverseur 2 non commandé, dont la sortie Q est bouclée sur son entrée A à travers un troisième inverseur 3 du même type que l'inverseur 1.

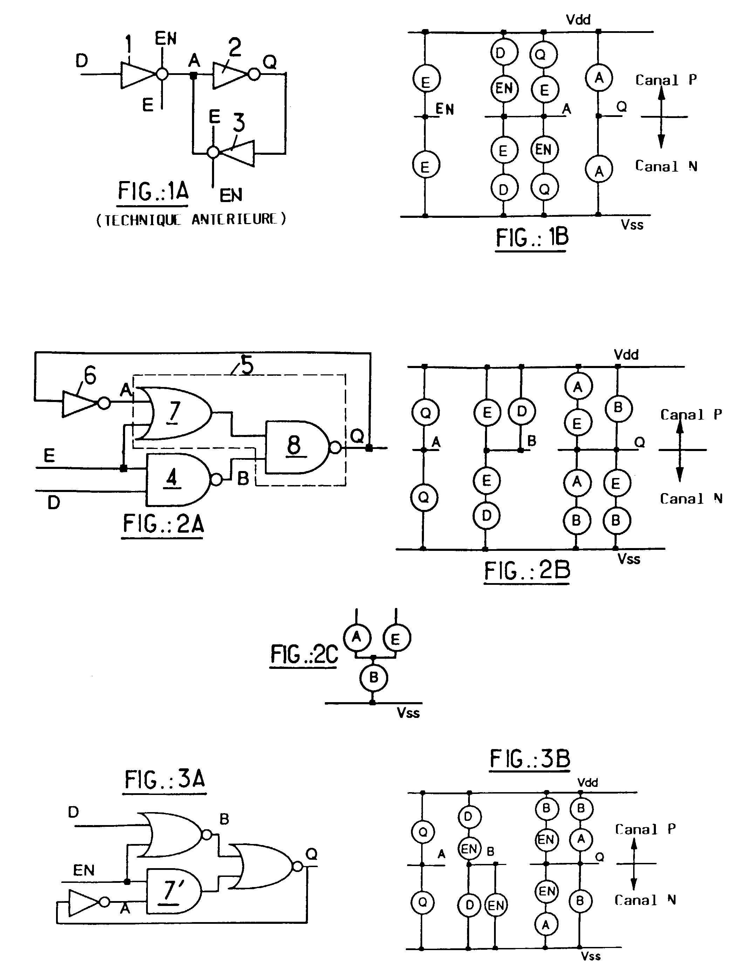

On a représenté à la figure 1B une topographie de transistors exécutant les fonctions logiques visibles sur la figure 1A, en technologie C2MOS. Chaque transistor est représenté par un cercle entourant la variable commandant la conduction dudit transistor, soit E, EN, A entrée de l'inverseur 2 de la figure 1A, D variable d'entrée, Q variable de sortie de l'inverseur 2. Les transistors sont groupés suivant leur type, canal P ou canal N et sont connectés "en branches" parallèles, entre une des bornes $V_{DD}$, $V_{SS}$ d'une source d'alimentation électrique et les noeuds de sortie des variables EN, A et Q.

On reconnaît ainsi sur la topographie de la figure 1B un inverseur constitué par deux transistors E montés en série entre $V_{DD}$ et $V_{SS}$, la borne commune de ces transistors délivrant classiquement EN, signal d'horloge complémentaire de E, comme cela est classique dans les circuits commandés par des horloges à deux phases complémentaires. Les inverseurs 1 et 3 sont constitués respectivement par les transistors D, EN canal P, connectés en série avec les transistors E, D canal N et par les transistors Q et E canal P, connectés en série avec les transistors EN, Q canal N, entre les deux bornes $V_{DD}$ et $V_{SS}$ de la source d'alimentation.

La structure "en branches" de cette topographie est favorable du point de vue de la compacité du circuit intégré ainsi conçu et donc du point de vue de l'abaissement de sa consommation électrique. Cependant, on observe que le transfert de la variable d'entrée D à la sortie Q de la bascule implique des transitions en série de trois "portes" désignées par la variable qu'elles délivrent, soit la porte EN constituée des deux transistors E situés à gauche de la figure 1B, la porte A constituée par les huit transistors situés au centre de cette figure et la porte Q constituée par les deux transistors A à droite de la figure. Ces trois transitions impliquent donc trois "délais" ou retards qui se cumulent, ce qui n'est pas favorable du point de vue de la rapidité du circuit. En outre, on remarque que la porte A est tirée à 1 à travers deux transistors MOS canal P dont on sait qu'ils ne sont pas très rapides.

La présente invention a pour but de réaliser des éléments de mémoire statique du type bascule D "latch" présentant une haute fréquence de fonctionnement ou une basse consommation d'énergie électrique, ou assurant un compromis satisfaisant entre ces deux caractéristiques antagonistes.

On atteint ce but de l'invention de l'invention, ainsi que d'autres qui apparaîtront à la lecture de la description qui va suivre, avec un élément de mémoire statique du type bascule "latch" propre à transférer une variable logique d'entrée $(D,\overline{D})$ sur une sortie $(Q; \overline{Q})$ de la bascule sous la commande d'un signal d'horloge (E; EN), comprenant des première (B) et deuxième $(Q; \overline{Q})$ portes logiques alimentées l'une par la variable logique d'entrée $(D,\overline{D})$ et toutes deux par le signal d'horloge (E; EN), cet élément étant remarquable en ce que la sortie de la première porte (B) alimente une entrée de la deuxième porte $(Q; \overline{Q})$ et en ce que la sortie de cette dernière est bouclée sur une entrée d'au moins une des portes.

Comme on le verra dans la suite, cette structure logique d'éléments de mémoire statique fait usage d'un signal d'horloge monophasique. On évite ainsi le délai nécessaire à l'inversion de celui-ci pour la production d'un signal d'horloge complémentaire et on gagne donc en rapidité. Le nombre de transistors connectés au signal d'horloge monophasique est aussi réduit par rapport au latch de la figure 1B, ce qui réduit la capacité et la consommation. C'est là un avantage important notamment dans des circuits à basse consommation que l'on souhaite faire fonctionner cependant à des fréquences élevées. La rapidité de la structure est encore accrue par l'utilisation d'un petit nombre de transistors agencés de manière compacte suivant une topographie en branches parallèles.

Suivant l'invention, la sortie de la deuxième porte $(Q; \overline{Q})$ est bouclée sur une de ses entrées à travers un inverseur (A) et/ou sur une des entrées de la première porte (B).

Suivant un premier mode de réalisation de l'élément de mémoire selon l'invention, la première porte (B) applique une première fonction logique élémentaire (NAND; NOR) au signal d'horloge (E; EN) et à l'une des variables du groupe constitué par : la variable logique d'entrée $(D,\overline{D})$ et la variable de sortie $(Q; \overline{Q})$ de la deuxième porte, celle-ci appliquant, d'une part, une deuxième fonction logique élémentaire (OR; AND) au même signal d'horloge et à l'autre variable dudit groupe $(D,\overline{D}; Q; \overline{Q})$ et, d'autre part, la première fonction logique élémentaire (NAND; NOR) à la sortie de la première porte (B) et au résultat de l'application de la deuxième fonction logique pour constituer la variable de sortie $(Q; \overline{Q})$ de l'élément de mémoire.

D'autres modes de réalisation de l'invention sont adaptés à la production d'une variable de sortie inversée $\overline{Q}$, à l'exploitation de la variable d'entrée D et de son complément $\overline{D}$ pour la réalisation d'éléments de mémoire sans course critique ou même sans aucune course, à l'exploitation du signal d'horloge EN plutôt que E, ou encore la production d'éléments de mémoire équipés de moyens de mise à 1 et/ou à 0 de la variable de sortie.

Suivant l'invention, ces éléments de mémoire prennent la forme d'un circuit intégré à transistors CMOS, comportant au moins deux portes logiques (B,Q; $\overline{Q}$) formées chacune par un premier groupe de transistors d'un premier type de conduction et d'un deuxième groupe de transistors d'un deuxième type de conduction, ces deux groupes de transistors étant montés en série entre les bornes ($V_{DD}$,$V_{SS}$) d'une source de tension d'alimentation et leur point de connexion commun formant le noeud de sortie de la porte, les chemins de conductions des transistors étant montés en série et/ou en parallèle à l'intérieur de chaque groupe de sorte que l'état de conduction de ces transistors déterminent le potentiel du noeud de sortie de la porte qui représente la variable interne fournie par cette porte et qui peut prendre des valeurs sensiblement égales à celles des deux bornes ($V_{SS}$,$V_{DD}$) de la source d'alimentation, les potentiels $V_{DD}$ et $V_{SS}$ étant lu chacun comme représentant l'un de deux états logiques, chaque transistor étant commandé par l'une des variables du groupe formé par : la variable de sortie de la porte B, la variable d'entrée (D,$\overline{D}$) le signal d'horloge (E; EN), la variable de sortie (Q; $\overline{Q}$), la variable A de sortie d'un éventuel inverseur de cette variable de sortie, et d'éventuelles variables (R,S) de forçage de la sortie de la porte (Q; $\overline{Q}$).

D'autres caractéristiques de la présente invention apparaîtront à la lecture de la description qui va suivre et à l'examen du dessin annexé dans lequel :

- les figures 1A, 1B illustrent un élément de mémoire statique ou "latch" de la technique antérieure, déjà décrit en préambule de la présente description,
- les figures 2A, 2B et 2C illustrent un premier mode de réalisation d'un élément de mémoire statique suivant la présente invention,
- les figures 3A, 3B, 4A, 4B, 5A, 5B, 6A, 6B, 7A, 7B illustrent cinq autres modes de réalisation de l'élément de mémoire suivant l'invention,
- les figures 8 et 10 illustrent le principe de moyens de mise à "1" ou "0" d'éléments de mémoire suivant l'invention, respectivement,
- les figures 9A, 9B représentent l'élément de mémoire des figures 2A à 2B, équipé des moyens de mise à "1" schématisés à la figure 8,
- les figures 11A, 11B représentent l'élément de mémoire des figures 2A, 2B équipé des moyens de mise à "0" schématisés à la figure 10,
- la figure 12 représente un élément de mémoire suivant l'invention, équipé à la fois de moyens de mise à "1" et de moyens de mise à "0", et
- les figures 13A, 13B représentent le latch des figures 5A, 5B, équipé de moyens de mise à "0".

On se réfère à la figure 2A du dessin annexé où l'on a représenté un premier mode de réalisation d'un élément de mémoire statique ou "latch" suivant l'invention, constitué essentiellement de deux portes logiques 4 et 5. La porte 4, ou B suivant le nom de sa variable de sortie, exécute une première fonction logique élémentaire faisant intervenir une variable d'entrée D et un signal d'horloge E. Dans le mode de réalisation représenté à la figure 2A, cette première fonction logique élémentaire est la fonction NAND (ou ET inversé).

La deuxième porte 5, ou Q du nom de sa variable de sortie, exécute une fonction logique plus complexe faisant intervenir le même signal d'horloge E et la sortie A d'un inverseur 6 placé dans une branche bouclant la sortie Q de cette deuxième porte sur l'entrée de l'inverseur 6. La deuxième porte 5 est ainsi constituée de deux portes logiques élémentaires 7 et 8, la porte 8 exécutant la même fonction logique NAND que la porte 4. La porte logique élémentaire 7 est une porte OR (OU) combinant la sortie $A = \overline{Q}$ de l'inverseur 6 et le signal d'horloge E. Dans certaines circonstances, l'inverseur 6 peut être omis comme on le verra plus loin. Dans la suite de la présente description, les portes 4, 5 et 6 seront désignées par les variables qu'elles délivrent, soit B, Q et A respectivement.

On a représenté à la figure 2B une topographie de transistors CMOS mettant en oeuvre la structure de latch schématisée à la figure 2A. On retrouve la disposition classique en deux groupes de transistors, canal P et canal N respectivement, déjà utilisée sur la figure 1B. Les noeuds de sortie A, B, Q communs à chaque paire de groupes de types opposés, correspondent aux sorties des trois portes définies en liaison avec la figure 2A. C'est ainsi qu'on retrouve l'inverseur A dans les deux transistors Q canal P et canal N respectivement, disposés en série entre les bornes $V_{DD}$, $V_{SS}$ de la source d'alimentation électrique. La porte B est constituée d'un premier groupe de transistors canal P comprenant un transistor E en parallèle avec un transistor D et d'un deuxième groupe de transistors canal N composé de transistors E et D en série. La porte Q est composée d'un premier groupe de transistors canal P comportant un transistor B en parallèle avec une branche comprenant un transistor A et un transistor E en série, et d'un deuxième groupe de transistors canal N formé d'une première branche comportant un transistor A et un transistor B en série, cette branche étant en parallèle avec une deuxième branche comprenant un transistor E en série avec un transistor B.

On constate que cette topographie compte treize transistors MOS alors que celle de la technique antérieure représentée à la figure 1B n'en compte que douze. Il est clair cependant que le nombre de transistors de la topographie de la figure 2B pourrait être ramenée à douze en remplaçant les deux transistors B placés dans les branches parallèles par un transistor B unique, comme représenté à la figure 2C. Surtout, on remarque que le délai entre l'horloge E et la sortie Q est constitué par le cumul des temps de transition de deux portes au maximum, celui de la porte B et celui de la porte Q, alors que le délai correspondant du multiplexeur des figures 1A, 1B est constitué par la somme des temps de transition de trois portes. Le latch suivant l'invention est donc plus rapide, à consommation égale, que celui des figures 1A, 1B.

En outre, une analyse détaillée sur une table d'états du latch de la figure 2B montre qu'il ne comporte qu'une seule course (entre les portes B et Q), introduisant des variations transitoires parasites des niveaux de tension lus sur la sortie Q, niveaux qui doivent normalement être égaux soit à $V_{DD}$ soit à $V_{SS}$. On évite ces variations très simplement, suivant l'invention, en faisant en sorte que l'une des portes transite plus rapidement que l'autre. Dans le cas présent, la porte B étant plus simple que la porte Q, il est facile, par un dimensionnement convenable des transistors MOS utilisés, d'obtenir que la porte B transite plus rapidement que la porte Q.

On remarquera encore que la transition à $V_{DD}$ de la porte Q est elle-même rapide puisque cette porte est tirée à "1" (soit $V_{DD}$) à travers un seul transistor canal P (le transistor B) et non à travers deux tels transistors, comme c'est le cas pour la porte A du circuit de la figure 1B.

On remarquera incidemment que pour obtenir la variable $\overline{Q} = A$ par le latch suivant l'invention, deux ou trois délais se cumulent (ceux des portes B, Q et A) et que l'obtention de $\overline{Q}$ n'est donc pas aussi rapide que celle de Q. On sait cependant que c'est la sortie Q du latch qui est la plus souvent utilisée, seule, et que la rapidité de l'obtention de cette sortie Q dans le latch suivant l'invention conserve donc tout son intérêt.

On remarquera encore que la topographie de la figure 2B ne comporte que 4 transistors commandés par l'horloge E alors que celle de la figure 1B comprend, outre ces 4 transistors, 2 transistors supplémentaires commandés par une horloge EN. Le latch suivant l'invention est freiné par les capacités d'entrées parasites de 4 transistors E seulement alors que celui de la figure 1B est freiné par celles de 6 transistors E ou EN. En outre, seules les capacités d'entrées des 4 transistors E du latch suivant l'invention sont chargées et déchargées cycliquement si Q = 0 l'horloge étant active. Par contre, si Q = 1 la porte B transite au rythme de l'horloge. Par comparaison, dans le latch de la figure 1B, l'inverseur A transite toujours au rythme de l'horloge, quel que soit Q. Enfin, la topographie du schéma "en branches" de la figure 2B est particulièrement compacte. Le latch de la figure 2B est ainsi plus rapide et consomme moins que celui de la figure 1B.

Bien entendu la forme duale de tout latch suivant l'invention peut constituer elle-même un tel latch. A titre d'exemple, on a ainsi représenté à la figure 3A le circuit dual du circuit de la figure 2A. Le circuit de la figure 3A comprend une première porte B du type NOR alimentée par la variable D et un signal d'horloge EN et une deuxième porte Q constituée d'une porte 7' du type AND alimentée par l'horloge EN et par la sortie d'un inverseur A, la sortie de cette porte 7' étant combinée avec la sortie de la porte B dans une autre porte NOR délivrant la sortie Q, bouclée à travers l'inverseur A sur la porte 7'. Le circuit de la figure 3A mémorise la donnée d'entrée D lorsque EN = 1 et reste transparent pour EN = 0 alors que c'était l'inverse pour le latch de la figure 2A.

La topographie de ce circuit est représentée à la figure 3B. Elle se déduit de la figure 2B par échange des horloges E et EN et échange des topographies des groupes de transistors canal N et canal B. Cette structure à 13 transistors MOS peut encore être réduite à 12 si les deux transistors B canal P de la porte Q sont réunis en un seul, à la manière de l'agencement représenté à la figure 2C.

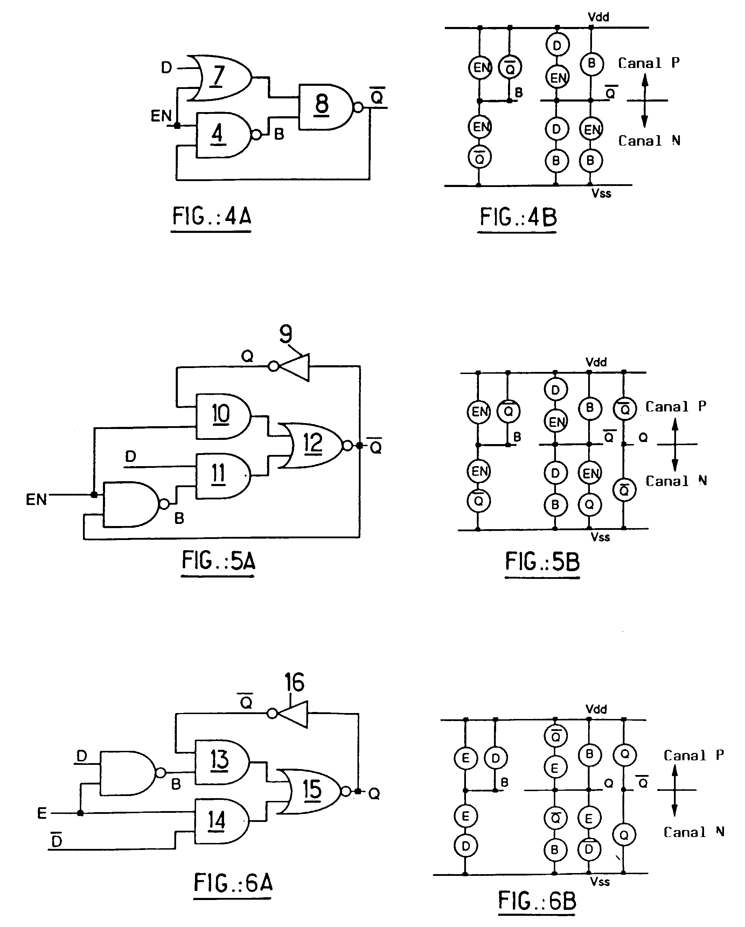

Les figures 4A et 4B représentent un autre mode de réalisation du latch suivant l'invention, fournissant seulement la sortie $\overline{Q}$. Il comprend des portes logiques élémentaires 4,7,8 identiques à celles du mode de réalisation de la figure 2A. Les entrées d'horloge des portes 4 et 7 sont alimentées par EN au lieu de E et la contre-réaction est établie entre la sortie $\overline{Q}$ et l'autre entrée de la porte 4 délivrant la variable interne B. La topographie de transistors représentée à la figure 4B met en oeuvre le schéma logique de la figure 4A. Cette topographie dérive de celle de la figure 2B par remplacement des transistors D et E par des transistors $\overline{Q}$ et EN respectivement, la porte A étant évidemment supprimée puisque la boucle de contre-réaction ne contient pas d'inverseur. La topographie compte onze transistors et pourrait même en compter dix seulement en confondant les deux transistors B canal N de la porte $\overline{Q}$ comme représenté à la figure 2C. La réduction du nombre des transistors par rapport à celui (12) du latch de la technique antérieure représenté à la figure 1B est avantageuse en ce qu'elle diminue le nombre de capacités parasites et accroît donc la rapidité du latch. Ce latch est "transparent" pour EN = 0 et transfère la variable d'entrée D sur $\overline{Q}$ pour EN = 1.

L'analyse du fonctionnement de ce latch sur table d'états fait apparaître que ce fonctionnement comporte une course critique entre les sorties B et $\overline{Q}$. Cette course est avantageusement supprimée en utilisant les mêmes mesures que celles décrites en liaison avec la figure 2B.

Le latch des figures 4A, 4B pourrait être modifié de manière à fournir aussi la variable Q, grâce à un inverseur alimenté par $\overline{Q}$. Le latch suivant l'invention représenté à la figure 5A dérive ainsi de celui de la figure 4A par addition d'un inverseur 9 (fournissant Q) dans une boucle de réaction supplémentaire établie entre la sortie de la porte $\overline{Q}$ et une entrée de cette porte. Les entrées de cette dernière sont distribuées sur deux portes AND 10 et 11, l'une (10) alimentée par Q et l'horloge EN, l'autre (11) par la variable D et la sortie de la porte B, les sorties des deux portes AND alimentant une porte NOR 12 délivrant $\overline{Q}$.

La topographie de transistors de la figure 5B met en oeuvre le schéma logique de la figure 5A. Cette topographie dérive de celle de la figure 4B par remplacement d'un transistor B canal N en série avec un transistor EN par un transistor Q et par addition d'un inverseur tirant Q de $\overline{Q}$. Cette topographie comporte treize transistors et ne peut être réalisée qu'en branches parallèles.

Une analyse sur tables d'états de ce latch démontre qu'il ne comporte aucune course. Il ne comprend que quatre transistors commandés par l'horloge EN. Aucune porte ne transite pour Q = 1 si l'horloge est active alors que pour Q = 0, la porte B transite avec l'horloge. Ces caractéristiques et sa topographie "en branches", très compacte, lui assurent des performances excellentes en matière de vitesse et de consommation.

On a vu ci-dessus comment supprimer la course du latch des figures 2A à 2C. Cette suppression peut aussi être obtenue si on dispose à la fois de l'entrée vraie D et de l'entrée complémentée $\overline{D}$, comme on va l'expliquer ci-dessous en liaison avec l'examen d'un autre mode de réalisation du latch suivant l'invention, représenté aux figures 6A et 6B.

Le schéma de la figure 6A comporte deux portes B et Q. La porte B est, comme dans les modes de réalisation précédents (sauf celui de la figure 3A), du type NAND et ses entrées sont alimentées par la variable D et l'horloge E. Les entrées $(\overline{Q},B)$ et $(E,\overline{D})$ de la porte complexe Q sont réparties entre deux portes AND 13 et 14 respectivement, dont les sorties alimentent une porte NOR 15 délivrant Q, un inverseur 16 alimenté par Q fournissant $\overline{Q}$ à la porte 13.

La topographie de transistors de la figure 6B, qui met en oeuvre le schéma logique de la figure 6A, dérive de celle de la figure 2B par substitution du transistor B canal N de la porte Q en série avec le transistor commandé par l'horloge E, par un transistor commandé par $\overline{D}$. Une analyse sur table d'états du latch des figures 6A, 6B fait apparaître une absence de course dans le cas où D et $\overline{D}$ transitent simultanément. Si $\overline{D}$ est produit par un inverseur, on observe une course non critique entre les variables B et $\overline{D}$, mais on n'observe pas sur la sortie Q la variation transitoire parasite du niveau de tension, ou "glitch", évoquée ci-dessus en liaison avec le mode de réalisation des figures 2A à 2C. La topographie de la figure 6B compte 13 transistors.

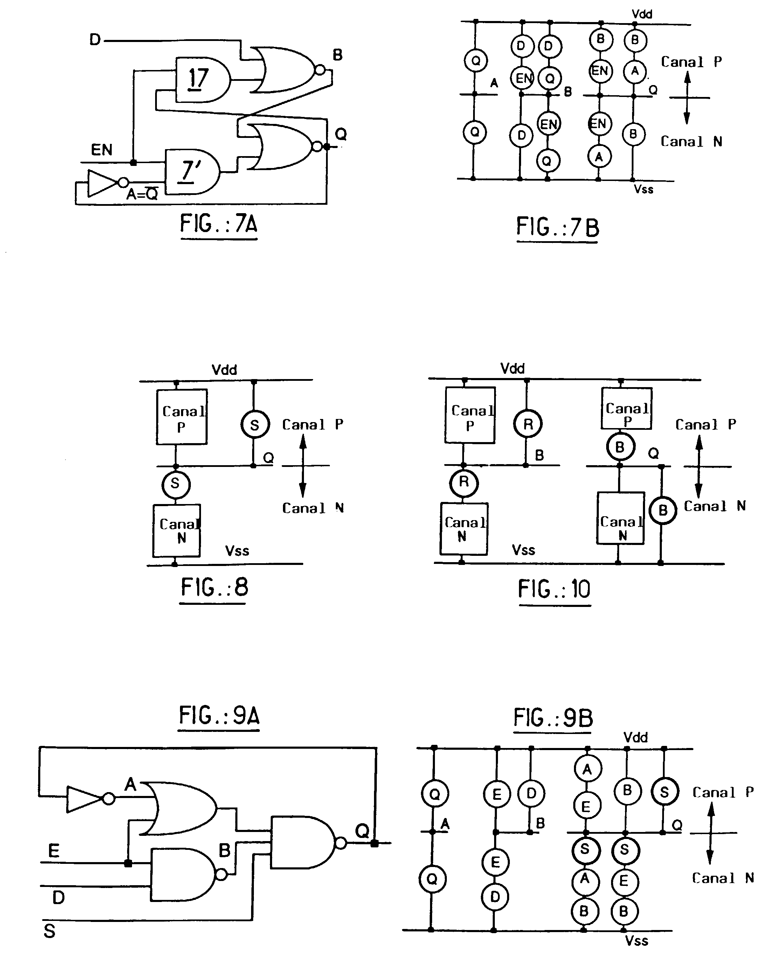

Le schéma logique de latch représenté à la figure 7A dérive de celui de la figure 3A par ajout d'une contre-réaction de la variable Q sur la variable B. Cette contre-réaction exige l'installation d'une porte AND 17 supplémentaire dont les entrées sont alimentées par Q et l'horloge EN et dont la sortie alimente la porte NOR qui délivre B, la porte B devenant ainsi une porte complexe "AND-NOR".

La topographie de transistors de la figure 7B, qui met en oeuvre le schéma de la figure 7A, dérive de celle de la figure 3B par addition d'une branche comportant un transistor D et un transistor Q en série, notée : (D série Q), dans la partie canal P de la porte B et addition d'un transistor Q en série avec le transistor commandé par EN dans la partie canal N de cette porte. Cette topographie compte 16 transistors (ou 14 si on confond les deux transistors B canal P de la porte Q comme on l'a expliqué ci-dessus).

L'analyse de ce latch sur tables d'états démontre que son fonctionnement ne comporte aucune course. En outre, on peut constater que si l'horloge E transite continuellement, avec l'entrée D fixée à 0, l'état interne B = 1, Q = 0, A = 1 ne change pas et de même qu'avec D fixé à 1, l'état interne B = 0, Q = 1, A = 0 ne change pas non plus. Ce latch est donc particulièrement économique du point de vue consommation.

On peut réduire le nombre de transistors de la topographie de la figure 7B en supprimant la branche (D série Q) de la partie canal P de la porte B. Le nombre de transistors est alors réduit à quatorze dans une topographie en branches parallèles et même à treize si on renonce à cette contrainte. Le schéma logique de la figure 7A n'est pas modifié par cette suppression mais une analyse de la table d'états de la topographie de transistors ainsi obtenue démontre qu'il existe une course entre les portes B et Q, mais seulement dans le cas marginal où on atteint l'état B = 0, Q = 0, A = 1 à la suite d'un bref passage à 1 de D alors que EN = 1. Cette course peut d'ailleurs être supprimée par les moyens évoqués en liaison avec des modes de réalisation décrits ci-dessus.

Bien entendu tous les latchs décrits jusqu'à présent peuvent être équipés de moyens de mise à "1" par des signaux de forçage S (de "SET") et/ou de moyens de mise à "0" par des signaux de forçage R (de "RESET") de la sortie Q. On a représenté de tels moyens de forçage à 1 ou à 0 aux figures 8 et 10 respectivement.

Sur le schéma logique de la figure 8, le forçage à 1 s'opère grâce à un transistor S canal P placé seul dans une branche parallèle aux autres branches de la partie canal P de la porte Q du latch, pour faire passer la tension du noeud de sortie Q à $V_{DD}$ quand son signal de commande S passe à 0, alors qu'un autre transistor S canal N recevant le même signal de commande S est placé en série avec toutes les branches canal N de la porte Q, pour bloquer alors tout passage de courant dans ces branches.

Les figures 9A, 9B représentent un latch conforme à celui des figures 2A, 2B, équipé de moyens de forçage à 1 de la porte Q sous la commande d'un signal S actif à 0 tel qu'on l'a décrit ci-dessus. Comme cela apparaît sur la topographie de transistors de la figure 9B, on trouve alors un transistor canal P commandé par S en parallèle sur les branches de la partie canal P de la porte Q et un autre tel transistor sur chacune des branches de transistors canal N de cette même porte.

Les latchs suivant l'invention peuvent de même être équipés de moyens de forçage à 0 de la sortie Q dont le principe est exposé schématiquement à la figure 10. On pourrait utiliser un principe dual de celui illustré par la figure 8 mais cela conduirait à introduire un troisième transistor, commandé par un signal R de remise à 0, actif à 0, dans une des branches de transistors canal P de la porte Q, ce qui ralentirait le latch car on sait que les transistors canal P ne sont pas très rapides.

Suivant l'invention, on surmonte cette difficulté en tirant à 1 au moins une variable interne du latch (la variable B par exemple) suivant le principe illustré à la figure 8, et en faisant en sorte que ce tirage à 1 ait pour effet de tirer Q à 0 quand la porte Q comporte des transistors commandés par B agencés de manière à obtenir ce résultat, comme représenté dans la partie droite de la figure 10.

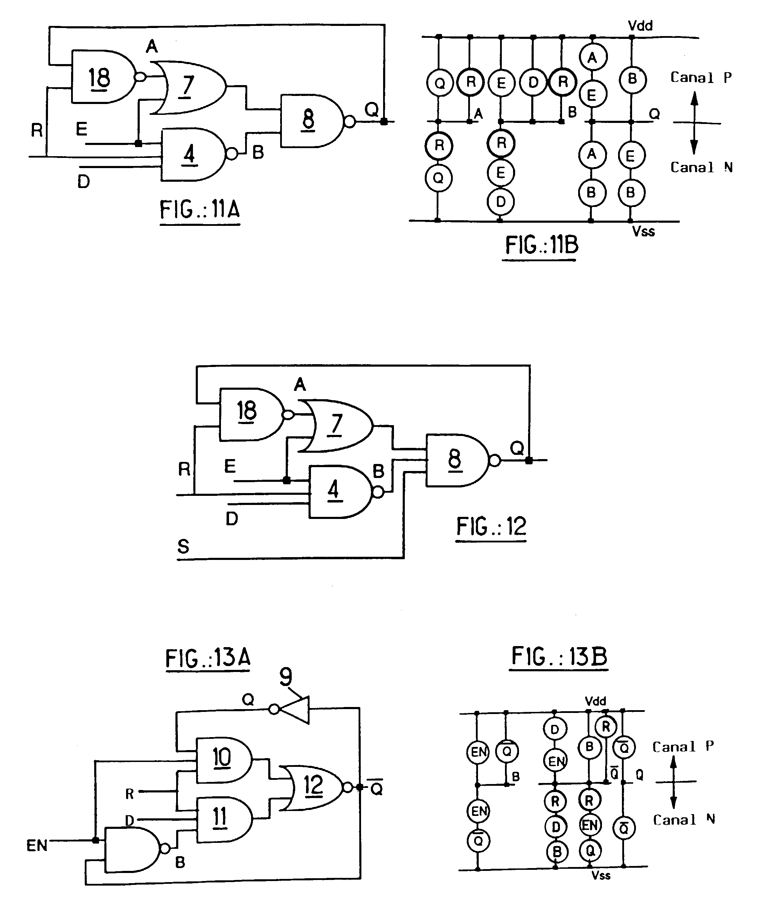

Aux figures 11A et 11B on a mis en oeuvre ce principe dans un latch du type de celui des figures 2A et 2B. On retrouve sur la figure 11A les portes 4, 7 et 8 de ce latch. Par contre l'inverseur 6 est remplacé par une porte NAND 18 alimentée par la variable Q et par la variable R de forçage à 0, active à 0, cette dernière variable étant aussi fournie à la porte B. Sur la figure 11B, il apparaît que des transistors commandés par R sont installés sur la porte A comme sur la porte B, pour tirer ces deux portes à 1 quand R = 0. La porte Q comprend une branche à deux transistors canal N en série commandée par A et B. Ainsi, quand les variables A et B sont toutes deux tirées à 1, la variable Q est tirée à 0, suivant le résultat recherché. La topographie de transistors de la figure 11B comporte dix sept transistors MOS, nombre que l'on peut réduire à seize en confondant les deux transistors commandés par B de la porte Q, comme on l'a vu ci-dessus à plusieurs reprises.

Ces moyens de forçage à 0 et à 1 peuvent évidemment être combinés dans un même latch, tel celui représenté schématiquement à la figure 12, qui dérive de celui de la figure 11A par addition d'une entrée de forçage S sur la porte 8 délivrant la sortie Q. Ils peuvent aussi être introduits séparément ou en combinaison dans tous les autres latchs suivant l'invention, comme illustré à titre d'exemple aux figures 13A, 13B. Le schéma du latch de la figure 13A dérive de celui du latch de la figure 5A par addition d'une entrée R de remise à 0 sur les deux portes AND 10 et 11. La topographie de transistors de la figure 13B illustre un mode de réalisation de ce latch. Cette topographie dérive de celle de la figure 5B par addition d'un transistor commandé par R en parallèle sur les branches canal P et un transistor commandé par R en série sur chaque branche canal N de la porte $\overline{Q}$, ceci pour tirer celle-ci à 1 et donc Q à 0 à la sortie de l'inverseur 9.

Il apparaît maintenant que l'invention permet de constituer des latchs qui peuvent être optimisés par rapport aux caractéristiques antagonistes que sont la consommation électrique et la fréquence de fonctionnement d'une part, et en ce qui concerne la compacité des topographies de transistors à utiliser pour réaliser de tels latchs. On notera en particulier l'amélioration de la rapidité qui résulte de l'utilisation d'un seul signal d'horloge et de l'utilisation de topographies essentiellement "en branches" parallèles pour améliorer la compacité de ces topographies, favorables à l'abaissement de la consommation électrique. Les latchs suivant l'invention se prêtent à une incorporation dans une "librairie" de circuits de base, utilisables de manière systématique par des concepteurs de circuits intégrés, notamment à basse consommation électrique.

Bien entendu l'invention n'est pas limitée aux modes de réalisation décrits et représentés, qui n'ont été donnés qu'à titre d'exemple. C'est ainsi que la présente invention couvre aussi toute forme duale non représentée des topographies décrites, de telles formes duales pouvant être établies sans effort par l'homme de métier à partir des enseignements contenus dans la présente description.

## Revendications

1. Elément de mémoire statique du type bascule "latch" propre à transférer une variable logique d'entrée (D,$\overline{D}$) sur une sortie (Q; $\overline{Q}$) de la bascule sous la commande d'un signal d'horloge (E; EN), comprenant des première (B) et deuxième (Q; $\overline{Q}$) portes logiques alimentées l'une par la variable logique d'entrée (D,$\overline{D}$) et toutes deux par le signal d'horloge (E; EN), caractérisé en ce que la sortie de la première porte (B) alimente une entrée de la deuxième porte (Q; $\overline{Q}$) et en ce que la sortie de cette dernière est bouclée sur une entrée d'au moins une des deux portes.

2. Elément de mémoire conforme à la revendication 1, caractérisé en ce que la sortie de la deuxième porte (Q; $\overline{Q}$) est bouclée sur une de ses entrées à travers un inverseur (A).

3. Elément de mémoire conforme à l'une quelconque des revendications 1 et 2, caractérisé en ce que la sortie de la deuxièmes porte (Q; $\overline{Q}$) est bouclée sur une des entrées de la première porte (B).

4. Elément de mémoire conforme à l'une quelconque des revendications 1 à 3, caractérisé en ce que la première porte (B) applique une première fonction logique élémentaire (NAND; NOR) au signal d'horloge (E; EN) et à l'une des variables du groupe constitué par la variable logique d'entrée (D,$\overline{D}$) et la sortie (Q; $\overline{Q}$) de la deuxième porte, et en ce que la deuxième porte applique, d'une part, une deuxième fonction logique élémentaire (OR; AND) au même signal d'horloge et à l'autre variable dudit groupe (D,$\overline{D}$; Q, $\overline{Q}$) et, d'autre part, la première fonction logique élémentaire (NAND; NOR) à la sortie de la première porte (B) et au résultat de l'application de la deuxième fonction logique pour constituer la variable de sortie (Q; $\overline{Q}$) de l'élément de mémoire.

5. Elément de mémoire conforme à la revendication 2, caractérisé en ce que la sortie ($\overline{Q}$) de la deuxième porte est bouclée à la fois sur une entrée de cette porte et sur une entrée de la première porte (B), en ce que la première porte applique une première fonction logique (NAND; NOR) à la sortie de la deuxième porte et au signal d'horloge (EN; E), en ce que la deuxième porte ($\overline{Q}$) applique une deuxième fonction logique élémentaire (AND; OR), d'une part audit signal d'horloge et à la sortie complémentée (Q) de la deuxième porte ($\overline{Q}$) et, d'autre part, à la variable d'entrée (D) et à la sortie de la première porte (B), les résultats des applications de cette deuxième fonction logique (AND; OR) étant combinés par une troisième fonction logique élémentaire (NOR; NAND) pour délivrer la sortie ($\overline{Q}$) de l'élément.

6. Elément de mémoire conforme à la revendication 2, caractérisé en ce que la première porte (B) applique une première fonction logique (NAND; NOR) à la variable d'entrée (D,D) et au signal d'horloge (E; EN), en ce que la deuxième porte (Q; $\overline{Q}$) applique une deuxième fonction logique élémentaire (AND; OR), d'une part, aux variables (B,$\overline{Q}$; B,$\overline{D}$), d'autre part, aux variables ($\overline{D}$,E; $\overline{D}$,B) et applique une troisième fonction logique (NOR; NAND) aux résultats des applications de la deuxième fonction logique.

7. Elément de mémoire conforme à la revendication 2, caractérisé en ce que la sortie (Q) de la deuxième porte est bouclée à la fois sur une entrée de cette porte et sur une entrée de la première porte (B), en ce que la première porte applique une première fonction logique élémentaire (AND; OR) aux variables (Q, EN; Q, E) et une deuxième fonction logique élémentaire (NOR; NAND) au résultat de l'application de la première fonction et à la variable d'entrée (D), et en ce que la deuxième porte (Q) applique la première fonction (AND; OR) aux variables ($\overline{Q}$, EN; $\overline{Q}$,E) et la deuxième fonction (NOR; NAND) au résultat de l'application de la première fonction et à la sortie (B) de la deuxième porte.

8. Elément de mémoire conforme à l'une quelconque des revendications 1 à 7, caractérisé en ce qu'il comprend au moins un des moyens du groupe formé par : des moyens (S) de mise à "1" de la sortie (Q) de la deuxième porte, des moyens (R) de mise à "0" de cette sortie.

9. Elément de mémoire conforme à l'une quelconque des revendications 1 à 8, caractérisé en ce qu'il prend la forme d'un circuit intégré à transistors CMOS, comportant au moins deux portes logiques (B,Q,$\overline{Q}$) formées chacune par un premier groupe de transistors d'un premier type de conduction et d'un deuxième groupe de transistors d'un deuxième type de conduction, ces deux groupes de transistors étant montés en série entre les bornes ($V_{DD}$,

$V_{SS}$) d'une source de tension d'alimentation et leur point de connexion commun formant le noeud de sortie de la porte, les chemins de conduction des transistors étant montés en série et/ou en parallèle à l'intérieur de chaque groupe de sorte que l'état de conduction de ces transistors détermine le potentiel du noeud de sortie de la porte qui représente la variable interne fournie par cette porte et qui peut prendre des valeurs sensiblement égales à celles des deux bornes ($V_{DD}$, $V_{SS}$) de la source d'alimentation, les potentiels ($V_{DD}$) et ($V_{SS}$) étant lus chacun comme représentant l'un des deux états logiques, chaque transistor étant commandé par l'une des variables du groupe formé par la variable de sortie de la porte (B), la variable d'entrée (D,$\overline{D}$), le signal d'horloge (E; EN), la variable de sortie (Q; $\overline{Q}$), la variable (A) de sortie d'un éventuel inverseur de cette variable de sortie, et d'éventuelles variables (R, S) de forçage de la sortie de la porte (Q; $\overline{Q}$).

10. Elément de mémoire conforme à l'ensemble des revendications 4 et 9, caractérisé en ce qu'il comprend les circuits logiques suivants (Figure 2B) désignés respectivement par la variable (A, B, Q) qu'ils délivrent et composés des transistors indiqués pour chaque groupe, désignés chacun par la variable (D, E, Q, A, B) qui le commande, la connexion des chemins de conduction de ces transistors étant indiquée dans chaque groupe par "série" ou "parallèle" et un montage indiqué entre parenthèses étant à considérer dans son ensemble :

   - inverseur A : premier groupe : Q, deuxième groupe : Q.
   - porte B : premier groupe : D parallèle E, deuxième groupe E série D.
   - porte Q : premier groupe : (A série E) parallèle B,
        deuxième groupe : (A série B) parallèle (E série
        B) ou (A parallèle E) série B.

11. Elément de mémoire conforme à l'ensemble des revendications 4 et 9, caractérisé en ce qu'il comprend les circuits logiques suivants (figure 4B), désignés respectivement par la variable interne (B, $\overline{Q}$) qu'ils délivrent et composés des transistors indiqués pour chaque groupe, désignés chacun par la variable (D, EN, $\overline{Q}$, B) qui le commande, la connexion des chemins de conduction de ces transistors étant indiquée dans chaque groupe par "série" ou "parallèle" et un montage indiqué entre parenthèses étant à considérer dans son ensemble :

   - porte B : premier groupe : EN parallèle $\overline{Q}$
        deuxième groupe : EN série $\overline{Q}$
   - porte $\overline{Q}$ : premier groupe : (D série EN) parallèle B

deuxième groupe : (D série B) parallèle (EN

série B) ou (D parallèle EN) série B.

**12.** Elément de mémoire conforme à la revendication 11, caractérisé en ce que ledit deuxième groupe de la porte $\overline{Q}$ est constitué par (D série B) parallèle (EN série Q) et en ce qu'il comprend en outre un circuit inverseur constitué de deux transistors ($\overline{Q}$) placés dans les premier et deuxième groupes, respectivement (Figure 5B).

**13.** Elément de mémoire conforme à l'ensemble des revendications 6 et 9, caractérisé en ce qu'il comprend les circuits logiques suivants (Figure 6B), désignés respectivement par la variable interne (B,Q; $\overline{Q}$) qu'ils délivrent et composés des transistors indiqués pour chaque groupe, désignés chacun par la variable (D,$\overline{D}$, E, Q; $\overline{Q}$, B), qui le commande, la connexion des chemins de conduction de ces transistors étant indiquée dans chaque groupe par "série" ou "parallèle" et un montage indiqué entre parenthèses étant à considérer dans son ensemble :

- porte B : premier groupe : E parallèle D
  deuxième groupe : E série D
- porte Q : premier groupe : ($\overline{Q}$ série E) parallèle B
  deuxième groupe : ($\overline{Q}$ série B) parallèle (E série $\overline{D}$)
- porte $\overline{Q}$ : premier groupe : Q
  deuxième groupe : Q.

**14.** Elément de mémoire conforme à l'ensemble des revendications 7 et 9, caractérisé en ce qu'il comprend les circuits logiques suivants (figure 7B), désignés respectivement par la variable interne (A, B, Q) qu'ils délivrent et composés des transistors indiqués pour chaque groupe, désignés chacun par la variable (D, EN, Q, A, B) qu'il commande, la connexion des chemins de conduction de ces transistors étant indiquée dans chaque groupe par "série" ou "parallèle" et un marquage indiqué entre parenthèses étant à considérer dans son ensemble :

- porte A : premier groupe : Q, deuxième groupe : Q
- porte B : premier groupe : D série EN
  deuxième groupe : D parallèle (EN série Q)
- porte Q : premier groupe : (B série EN) parallèle (B série A) ou B série (EN parallèle A)
  deuxième groupe : (EN série A) parallèle B.

**15.** Elément de mémoire conforme à la revendication 14, caractérisé en ce que la branche (D série EN) du premier groupe de la porte B est en parallèle avec une branche (D série Q).

**16.** Elément de mémoire conforme à l'une quelconque des revendications 9, 10 et 12 à 15, comprenant des moyens de forçage à "1" de la variable (Q) de sortie sous la commande d'un signal (S) actif à "0", caractérisé en ce qu'il comprend, dans le premier groupe de transistors de la porte (Q), un transistor (S) en parallèle avec les autres branches et, dans le deuxième groupe, un transistor (S) en série sur chaque branche (Figure 8).

**17.** Elément de mémoire conforme à l'une quelconque des revendications 9, 10 et 12 à 16, comprenant des moyens de forçage à "0" de la variable (Q) de sortie sous la commande d'un signal (R) actif à "0", caractérisé en ce que ces moyens comprennent des moyens de mise "1" d'au moins une variable interne (A, B, $\overline{Q}$) commandant la mise à "0" de la variable (Q) (Figure 10).

FIG.:1A
(TECHNIQUE ANTERIEURE)

FIG.: 1B

FIG.:2A

FIG.: 2B

FIG.:2C

FIG.: 3A

FIG.:3B

FIG.:4A

FIG.:4B

FIG.:5A

FIG.:5B

FIG.:6A

FIG.:6B

FIG.:7A

FIG.:7B

FIG.:8

FIG.:10

FIG.:9A

FIG.:9B

FIG.: 11A

FIG.: 11B

FIG.: 12

FIG.: 13A

FIG.: 13B

Office européen

des brevets

**RAPPORT DE RECHERCHE EUROPEENNE**

Numero de la demande

EP 95 40 2715

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | EP-A-0 496 171 (TOSHIBA) <br> * abrégé * <br> * colonne 1, ligne 5 - colonne 1, ligne 15; figure 1A * <br> --- | 1,2 | G11C11/412 <br> H03K3/037 <br> H03K3/356 |
| A | US-A-4 227 097 (PIGUET) <br><br> * abrégé * <br> * colonne 2, ligne 21 - colonne 7, ligne 28; figures 1-5 * <br> --- | 1,2, 10-14 | |
| A | BULLETIN ANNUEL DE LA SOCIETE SUISSE DE CHRONOMETRIE, <br> vol. 7, no. 2, 1976, NEUCHATEL CH, <br> pages 159-163, XP002001341 <br> VITTOZ ET AL.: "CIRCUITS CMOS PSEUDO-STATIQUES" <br> * page 162, colonne de gauche, ligne 31 - page 162, colonne de droite, ligne 3; figure 8 * <br> ----- | 1,2, 10-14 | |

**DOMAINES TECHNIQUES RECHERCHES (Int.Cl.6)**

G11C
H03K

Le présent rapport a été établi pour toutes les revendications

| Lieu de la recherche | Date d'achèvement de la recherche | Examinateur |
|---|---|---|
| LA HAYE | 23 Avril 1996 | Stecchina, A |